(19) Europäisches Patentamt / European Patent Office / Office européen des brevets

(11) **EP 3 069 386 B1**

(12) **FASCICULE DE BREVET EUROPEEN**

(45) Date de publication et mention
de la délivrance du brevet:
**02.08.2017 Bulletin 2017/31**

(21) Numéro de dépôt: **14814918.0**

(22) Date de dépôt: **12.11.2014**

(51) Int Cl.:
*H01L 31/0224* (2006.01)   *H01L 31/0392* (2006.01)
*H01L 31/046* (2014.01)

(86) Numéro de dépôt international:
**PCT/FR2014/052877**

(87) Numéro de publication internationale:
**WO 2015/071589 (21.05.2015 Gazette 2015/20)**

(54) **SUBSTRAT DE CONTACT ARRIÈRE POUR CELLULE PHOTOVOLTAÏQUE**

RÜCKKONTAKTSUBSTRAT FÜR EINE PHOTOVOLTAISCHE ZELLE

REAR CONTACT SUBSTRATE FOR PHOTOVOLTAIC CELL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **15.11.2013 FR 1361191**

(43) Date de publication de la demande:
**21.09.2016 Bulletin 2016/38**

(73) Titulaire: **Saint-Gobain Glass France
92400 Courbevoie (FR)**

(72) Inventeurs:
• **LEYDER, Charles
F-75019 Paris (FR)**

• **PALM, Jörg
80797 Munich (DE)**

(74) Mandataire: **Saint-Gobain Recherche
Département Propriété Industrielle
39 Quai Lucien Lefranc
93300 Aubervilliers (FR)**

(56) Documents cités:
**WO-A1-02/065554      WO-A1-2009/080931
WO-A1-2013/062298    WO-A1-2013/068702
US-A- 5 626 688**

## Description

L'invention se rapporte au domaine des cellules photovoltaïques, plus particulièrement au domaine des substrats conducteurs à base de molybdène utilisés pour fabriquer des cellules photovoltaïques à couches minces.

En effet, de façon connue, certaines cellules photovoltaïques à couches minces, dites de seconde génération, utilisent un substrat de contact arrière à base de molybdène revêtu d'une couche d'agent absorbeur (i.e. matériau photoactif), généralement en chalcopyrite de cuivre Cu, d'indium In, et de sélénium Se et/ou de soufre S. Il peut s'agir, par exemple, d'un matériau du type $CuInSe_2$. Ce type de matériau est connu sous l'abréviation CIS. Il peut également s'agir de CIGS c'est-à-dire d'un matériau incorporant en outre du gallium, ou encore de matériaux du type $Cu_2(Zn,Sn)(S,Se)_4$ (i.e. CZTS), utilisant du zinc et/ou de l'étain plutôt que de l'indium et/ou du gallium. Un troisième type de matériau est à partir de tellure de cadmium (CdTe) et du sulfure de cadmium (CdS).

Pour ce type d'application, les électrodes sont le plus souvent à base de molybdène (Mo) car ce matériau présente un certain nombre d'avantages.

C'est un bon conducteur électrique (résistivité relativement faible de l'ordre de $10\mu\Omega.cm$).

Il peut être soumis aux traitements thermiques élevés nécessaires, car il a un point de fusion élevé (2610°C).

Il résiste, dans une certaine mesure, au sélénium et au soufre. Le dépôt de la couche d'agent absorbeur impose le plus souvent un contact avec une atmosphère contenant du sélénium ou du soufre qui tend à détériorer la plupart des métaux. Le molybdène réagit avec le sélénium ou le soufre notamment, formant du $MoSe_2$, $MoS_2$ ou $Mo(S,Se)_2$, mais garde l'essentiel de ses propriétés, notamment électriques, et conserve un contact électrique adéquat avec par exemple la couche de CIS, de CIGS, de CZTS ou de CdTe.

Enfin, c'est un matériau sur lequel les couches de type CIS, CIGS, CZTS ou CdTe adhèrent bien, le molybdène tend même à en favoriser la croissance cristalline.

Cependant, le molybdène présente un inconvénient important quand on envisage une production industrielle : c'est un matériau coûteux. En effet, les couches en molybdène sont habituellement déposées par pulvérisation cathodique (assistée par champ magnétique). Or les cibles de molybdène sont onéreuses. Cela est d'autant moins négligeable que pour obtenir le niveau de conductance électrique voulu (une résistance par carré inférieure ou égale à $2\Omega/\square$, et de préférence inférieure ou égale à 1 ou même $0,5\Omega/\square$ après traitement dans une atmosphère contenant du S ou du Se), il faut une couche de Mo relativement épaisse, généralement de l'ordre de 400 nm à 1 micromètre.

La demande de brevet WO-A-02/065554 de SAINT-GOBAIN GLASS FRANCE enseigne de prévoir une couche relativement mince de molybdène (inférieure à 500nm) et de prévoir une ou plusieurs couches imperméables aux alcalins entre le substrat et la couche à base de molybdène, de façon à préserver les qualités de la fine couche à base de molybdène lors des traitements thermiques subséquents.

Ce type de substrat de contact arrière reste néanmoins relativement coûteux. WO 2013/062298 A1 divulgue un substrat de contact arrière pour cellule photovoltaïque comprenant un substrat porteur et un revêtement en Mo, le revêtement en Mo présentant une tranchée de gravure traversante et une couche enrobante recouvrant, à l'intérieur de la tranchée de gravure, la tranche du revêtement en Mo. Un but de la présente invention est de fournir un nouveau substrat de contact arrière à base de molybdène dont le coût de fabrication soit relativement faible.

A cet effet, la présente invention a notamment pour objet un substrat de contact arrière pour cellule photovoltaïque, comprenant un substrat porteur et un revêtement électrode comprenant une couche principale métallique, le revêtement électrode présentant au moins une tranchée de gravure traversant ladite couche principale métallique, dans lequel le substrat de contact arrière comprend une couche enrobante barrière à la sélénisation recouvrant, à l'intérieur de la tranchée de gravure, la tranche de la couche principale métallique, dans lequel ladite couche enrobante barrière à la sélénisation est à base d'au moins un nitrure ou d'au moins un oxynitrure métallique d'un métal choisi parmi le titane, le molybdène, le zirconium ou le tantale et une teneur en oxygène $x=O/(O+N)$ avec $x=0$ ou $0<x<1$. Un tel substrat de contact arrière présente l'avantage de permettre d'obtenir, avec des épaisseurs moindres de molybdène, une résistance par carré équivalente à celle d'un substrat de contact arrière dont le revêtement électrode est constitué d'une seule couche de molybdène.

Il s'est avéré que la couche de passivation pouvait de la sorte empêcher une sélénisation de la couche principale métallique sur l'ensemble de sa surface à partir des tranchées P1, y compris dans le cas d'une couche principale métallique à base de cuivre, particulièrement sensible à la sélénisation.

La présence d'une couche barrière à la sélénisation sur la couche principale et sous la couche supérieure métallique permet en outre de garantir la présence et la quantité de diséléniure et/ou disulfure de métal (e.g. $Mo(S,Se)_2$) par la transformation de l'intégralité de la couche supérieure (par exemple si son épaisseur est entre 10 et 50nm) tout en garantissant la présence et une épaisseur uniforme d'une couche principale métallique dont les propriétés de conductance ont été préservées.

L'uniformité de la couche de contact ohmique formée par la couche supérieure après sélénisation et/ou sulfuration bénéficie en outre à l'efficacité de la cellule solaire.

Suivant des modes particuliers de réalisation, le substrat de contact arrière comporte l'une ou plusieurs des caractéristiques suivantes, prise(s) isolément ou suivant toutes les combinaisons techniquement possibles :

- le revêtement électrode formé sur le substrat porteur ;
- la couche principale métallique formée sur le substrat porteur ;
- le revêtement électrode comprend une couche recouvrante barrière à la sélénisation formée sur la couche principale métallique ;
- ladite couche enrobante barrière à la sélénisation est à base d'au moins un nitrure ou d'au moins un oxynitrure métallique d'un métal choisi parmi le titane, le molybdène, le zirconium ou le tantale et une teneur en oxygène x=O/(O+N) avec x= 0 ou 0<x<1, de préférence 0,05<x<0,95, de préférence 0,1<x<0,9 ;
- ladite couche enrobante barrière à la sélénisation est un composé à base de molybdène avec une teneur élevée en oxygène et/ou en azote ;
- ladite couche enrobante barrière à la sélénisation a une résistivité comprise entre 20μOhm.cm et 50μOhm.cm ;
- le substrat comprend, sur la couche principale métallique, une couche supérieure métallique à base d'un métal M propre à former, après sulfuration et/ou sélénisation, une couche de contact ohmique avec un matériau semi-conducteur photoactif, avec interposition éventuelle d'autres couches, notamment interposition d'une couche recouvrante barrière à la sélénisation formée sur la couche principale métallique ;
- ledit métal M est propre à former un composé de type sulfure et/ou séléniure semi-conducteur de type p avec une concentration de porteurs de charge supérieure ou égale à $10^{16}$/cm$^3$ et un travail de sortie supérieur ou égal à 4,5eV ;
- ladite couche supérieure à base d'un métal M est à base de molybdène et/ou de tungstène ;
- ladite couche recouvrante barrière à la sélénisation et ladite couche enrobante barrière à la sélénisation sont deux parties d'une même couche ;
- ladite couche recouvrante barrière à la sélénisation et ladite couche enrobante barrière à la sélénisation sont deux couches distinctes, ladite couche enrobante barrière à la sélénisation étant dans la tranchée de gravure.

L'invention a également pour objet un dispositif semi-conducteur comprenant un substrat porteur et un revêtement électrode formé sur le substrat porteur, le revêtement électrode comprenant :

- une couche principale métallique ;
- une couche de contact ohmique à base d'un composé de type sulfure et/ou séléniure d'un métal M, sur la couche principale métallique ;

- une couche photoactive en un matériau semi-conducteur photoactif à base de chalcopyrite de cuivre et de sélénium et/ou de soufre, par exemple un matériau de type $Cu(In,Ga)(S,Se)_2$, notamment CIS ou CIGS, ou encore un matériau de type $Cu_2(Zn,Sn)(S,Se)_4$, la couche photoactive étant formée sur la couche de contact ohmique (26) ; et

dans lequel le revêtement électrode présente au moins une tranchée de gravure traversant au moins ladite couche principale métallique et dans lequel le substrat de contact arrière comprend une couche enrobante barrière à la sélénisation recouvrant, à l'intérieur de la tranchée de gravure, la tranche de la couche principale métallique, dans lequel ladite couche enrobante barrière à la sélénisation est à base d'au moins un nitrure ou d'au moins un oxynitrure métallique d'un métal choisi parmi le titane, le molybdène, le zirconium ou le tantale et une teneur en oxygène x=O/(O+N) avec x=0 ou 0<x<1. Suivant des modes particuliers de réalisation, le dispositif ci-dessus comporte l'une ou plusieurs des caractéristiques suivantes, prise(s) isolément ou suivant toutes les combinaisons techniquement possibles :

- le matériau de la couche de contact ohmique est un matériau semi-conducteur de type p avec une concentration de porteurs de charge supérieure ou égale à $10^{16}$/cm$^3$ et un travail de sortie supérieur ou égal à 4,5eV ;
- la couche de contact ohmique est à base d'un composé de type sulfure et/ou séléniure de molybdène et/ou de tungstène ;

L'invention a encore pour objet une cellule photovoltaïque comprenant un dispositif semi-conducteur tel que décrit ci-dessus, et un revêtement électrode transparent formé sur la couche photoactive.

L'invention a encore pour objet un module photovoltaïque comprenant plusieurs cellules photovoltaïques formées sur le substrat porteur et reliées entre elles en série. Un procédé de fabrication d'un substrat de contact arrière pour cellule photovoltaïque comprend des étapes consistant à :

déposer une couche principale métallique sur un substrat porteur;
former une tranchée par gravure à travers la couche principale métallique, et

- déposer une couche enrobante barrière à la sélénisation recouvrant la tranche de la couche principale métallique, à l'intérieur de la trachée de gravure.

Suivant des modes particuliers de réalisation, le procédé présente l'une ou plusieurs des caractéristiques suivantes, prise(s) isolément ou suivant toutes les combinaisons techniquement possibles :

- le procédé comprend une étape de dépôt d'un masque à travers lequel la gravure est effectuée, le dépôt de ladite couche enrobante barrière à la sélénisation s'effectuant sur et à travers le masque, et une étape de retrait du masque ;
- le procédé comprend une étape consistant à former une deuxième tranchée de gravure sur la première tranchée de gravure et de largeur inférieure à la première tranchée de gravure ;
- le procédé comprend une étape de transformation de la couche supérieure à base de métal M en un sulfure et/ou séléniure du métal M ;
- le procédé comprend une étape de formation d'une couche photoactive par sélénisation et/ou sulfuration, sur ladite couche supérieure à base d'un métal M, ladite couche supérieure à base d'un métal M étant transformée avant ou pendant la formation de ladite couche photoactive, de préférence pendant ;
- après sulfuration et/ou sélénisation, ladite couche supérieure est à base d'un semi-conducteur de type p avec une concentration de porteurs de charge supérieure ou égale à $10^{16}/cm^3$ et un travail de sortie supérieur ou égal à 4,5eV ;
- l'étape de formation de la couche photoactive comprend une étape de sélénisation et/ou sulfuration à une température supérieure ou égale à 300°C.

Un autre objet de l'invention est un module photovoltaïque comprenant une pluralité de cellules photovoltaïques reliées entre elles en série et toutes formées sur le même substrat, dans lequel les cellules photovoltaïques sont telles que décrites ci-dessus.

L'invention sera mieux comprise à la lecture de la description qui va suivre, donnée uniquement à titre d'exemple, et faite en référence aux dessins annexés, sur lesquels :

- la figure 1 est une vue schématique en coupe d'un substrat de contact arrière selon l'invention sur lequel une tranchée de gravure a été réalisée avant dépôt d'une couche protectrice ;
- la figure 2 est une vue schématique en coupe illustrant les différentes gravures réalisées lors de la fabrication de modules photovoltaïques ;
- les figures 3a-3c sont des vues schématiques en coupe et en perspective illustrant les différentes étapes de fabrication du module de la figure 2, et les figures 4a-4c une illustration d'un type alternatif de gravure ;
- les figures 5a-5d sont des vues analogues à la figure 1 illustrant des étapes de fabrication du substrat de contact arrière de la figure 1 ;
- la figure 6 est une vue schématique en coupe illustrant les différentes couches déposées sur le substrat de contact arrière ;
- les figures 7 et 8 sont des vues analogues à la figure 1 illustrant des variantes de réalisation.

Les dessins ne sont pas à l'échelle, pour une représentation claire, car les différences d'épaisseur entre notamment le substrat porteur et les couches déposées sont importantes, par exemple de l'ordre d'un facteur 500.

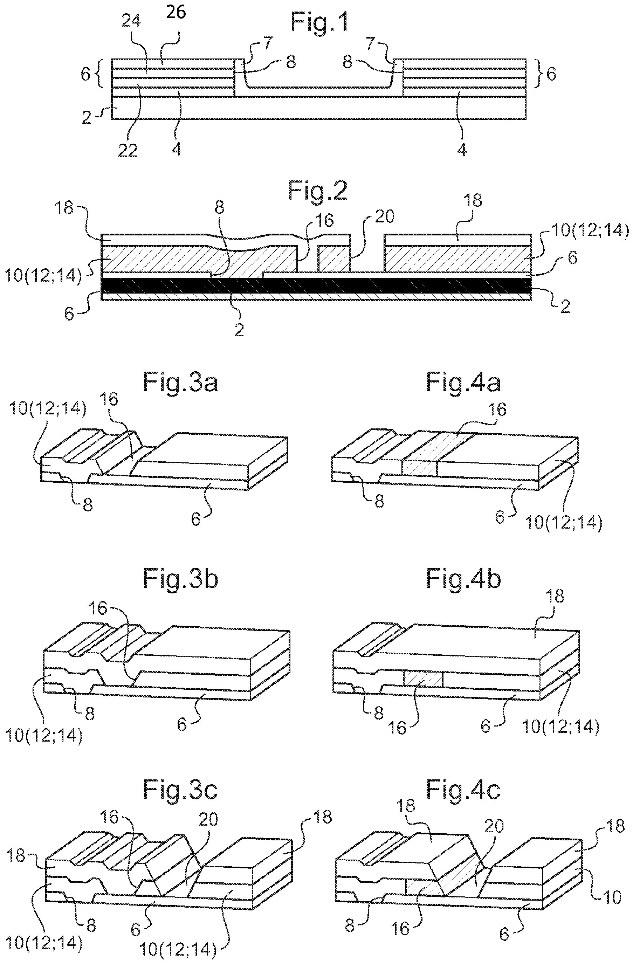

Sur la figure 1 est illustré un substrat de contact arrière 1 pour cellule photovoltaïque comprenant :

- un substrat porteur 2 en verre ;
- une couche barrière aux alcalins 4 formée sur le substrat 2 ;
- un revêtement électrode 6 formé sur la couche barrière aux alcalins 4,
- une couche de passivation 7 dans une tranchée 8 de gravure de type P1 du revêtement électrode 6.

On entend, dans tout le texte, par « une couche A formée (ou déposée) sur une couche B », une couche A formée soit directement sur la couche B et donc en contact avec la couche B, soit formée sur la couche B avec interposition d'une ou plusieurs couches entre la couche A et la couche B.

A noter qu'on entend dans tout le texte par « revêtement électrode », un revêtement d'amenée de courant comprenant au moins une couche électroniquement conductrice, c'est-à-dire dont la conductivité est assurée par la mobilité des électrons.

On entend également par « un matériau à base de A » un matériau principalement composé de A, de façon à obtenir la fonction recherchée. Le matériau contient de préférence au moins 80% de A en pourcentage atomique, par exemple au moins 90% de A en pourcentage atomique. Si le matériau est « à base de A et de B », on entend également qu'il contient de préférence au moins 80% de A et B en pourcentage atomique total, par exemple au moins 90% de A et B en pourcentage atomique total.

En outre, dans tout le texte, « comprend une couche » doit bien entendu s'entendre comme « comprend au moins une couche ».

La tranchée 8 de gravure est de type P1. Elle traverse toutes les couches jusqu'au substrat. Il s'agit d'une, et généralement de plusieurs gravures longitudinales délimitant et isolant électriquement différents segments du revêtement électrode, lesquels segments fonctionneront chacun comme des cellules photovoltaïques reliées en série, de façon connue.

La figure 2 illustre les différentes gravures réalisées lors de la fabrication du module photovoltaïque pour former dans le même substrat plusieurs cellules photovoltaïques reliées en série.

La gravure 8 de type P1 est la première. Elle est réalisée après fabrication du revêtement électrode et avant dépôt de la couche photoactive 10, dite également couche d'absorbeur, qui sera décrite plus en détail ci-dessous. La couche photoactive est optionnellement recouverte d'une couche tampon 12, par exemple de CdS et d'une éventuelle couche de ZnO intrinsèque (non représentée), comme expliqué également plus loin ci-dessous.

Une fois la couche photoactive 10 et les éventuelles couches 12 et 14 déposées, une seconde gravure 16, dite de type P2 est réalisée à travers la couche photoactive 10 et les éventuelles couches 12 et 14, sans traverser le revêtement électrode 6, ou du moins sans le traverser complètement. Il s'agit également de gravures longitudinales, parallèles aux gravures P1 (voir figure 3a).

Un revêtement électrode supérieur 18, par exemple à base de ZnO :Al, est ensuite déposé sur le substrat 2 (voir figure 3b). Il emplit au moins partiellement les tranchées 16 de gravure P2 de sorte à réaliser un contact électrique avec le revêtement électrode inférieur 6.

A noter que le revêtement électrode inférieur 6 est également appelé revêtement électrode arrière 6 car destiné à recevoir la lumière incidente après seulement que la lumière a traversé d'abord le revêtement électrode supérieur 18 (ou « revêtement électrode avant ») puis la couche photoactive 10.

Des gravures 20 de type P3 (figure 3c) sont ensuite réalisées, également de façon à former des tranchées 20 rectilignes et parallèles aux gravures précédentes. Les tranchées 20 traversent complètement le revêtement électrode supérieur 18 et au moins partiellement la couche photoactive 10 de façon à isoler les différents revêtements électrodes supérieurs des différentes cellules photovoltaïques reliées en série.

En variante, comme illustré sur les figures 4 a-c, la connexion électrique entre le revêtement électrode supérieur 18 et le revêtement électrode inférieur 6 de la cellule photovoltaïque adjacente n'est pas réalisée au moyen d'une gravure de type P2 mais par irradiation laser de la couche photoactive 10 et éventuelles couches 12 et 14, destinée à transformer la portion irradiée 16 en une portion électriquement conductrice.

L'invention concerne plus particulièrement le substrat de contact arrière 1 avant dépôt de la couche photoactive 10.

Selon l'invention, la tranchée 8 de gravure P1 est recouverte au moins partiellement d'une couche de passivation 7, de façon à protéger le revêtement électrode 6 sur sa tranche contre la sélénisation.

Le revêtement électrode 6 du substrat de contact arrière 1 illustré en figure 1 est constitué :

- d'une couche principale métallique 22 formée directement sur la couche barrière aux alcalins 4 ;
- d'une couche barrière à la sélénisation 24 de faible épaisseur formée directement sur la couche principale métallique 22 ; et
- d'une couche supérieure métallique 26 à base d'un métal M, formée directement sur la couche barrière à la sélénisation 24.

La tranchée 8 de gravure P1 traverse toutes les couches du revêtement électrode 6.

La couche de passivation 7 recouvre, à l'intérieur de la trachée 8 de gravure P1, la tranche de toutes les couches du revêtement électrode 6, notamment la tranche de la couche principale métallique 22, et protège ainsi le revêtement électrode 6 d'une sélénisation et/ou sulfuration éventuelle au niveau de la ou des tranchée(s) 8 de type P1.

Dans l'exemple illustré sur la figure 1, la couche de passivation 7 n'est présente que dans la tranchée de type P1, ce par exemple grâce à un procédé de masquage, par exemple au moyen d'une résine, comme expliqué plus en détail ci-dessous.

Il s'est avéré que grâce à la couche de passivation 7, l'ensemble de la surface de la couche principale métallique 26 se trouvait protéger, ce qui a mis en évidence a posteriori que la sélénisation était capable de se propager depuis la tranchée 8 de gravure à l'ensemble de la surface de la couche principale métallique, bien que celle-ci était protégée par le dessus. La couche de passivation 7, bien que très localisée, évite une destruction de la totalité du revêtement électrode 6.

A noter qu'en variante, la couche supérieure métallique 26 et/ou la couche barrière à la sélénisation 24 n'ont pas leur tranche recouverte par la couche de passivation dans la tranchée de gravure P1.

D'une manière générale, la couche de passivation 7 recouvre au moins la tranche de la couche principale métallique 22 dans la tranchée 8 de gravure P1.

On entend par « couche de passivation » ou « couche barrière à la sélénisation », la même chose du point de vue de la fonction de protection du matériau contre la sélénisation. Ces couches ont un nom différent pour les distinguer. Elles sont composées d'un matériau ayant la même fonction de protection contre la sélénisation.

Comme expliqué plus en détail ci-dessous, les contraintes de résistivité ne sont cependant pas les mêmes pour la couche de passivation, qui doit être suffisamment isolante pour éviter un « shunt » entre les cellules photovoltaïques et pour la couche barrière à la sélénisation, qui doit être suffisamment conductrice pour maintenir une conductance appropriée du revêtement électrode 6.

On entend par « couche de passivation » ou « couche barrière à la sélénisation », une couche d'un matériau de tout type adapté pour empêcher ou réduire la sélénisation des couches couvertes par la couche de passivation ou la couche barrière à la sélénisation lors du dépôt, sur la couche de passivation ou la couche barrière à la sélénisation, de couches de matériaux semi-conducteurs formés par sélénisation et/ou sulfuration. La couche de passivation 7 et la couche barrière à la sélénisation 24 au sens de l'invention montrent une efficacité prouvée même à une épaisseur de 3nm.

Un test possible pour savoir si un matériau est adapté ou non pour un rôle de barrière à la sélénisation (ou de passivation) du point de vue de la protection contre la sélénisation est de comparer un échantillon avec et sans une couche de 5nm de ce matériau entre la couche supérieure 26 à base d'un métal M et la couche principale 22 et de faire subir une sélénisation aux échantillons, par exemple par chauffage à 520°C dans une atmosphère à 100% de sélénium. Si la sélénisation de la couche principale 22 est réduite ou empêchée et la couche supérieure 26 entièrement sélénisée, le matériau est efficace. Ce test est également valable pour déterminer si le matériau de la couche de passivation 7 est adapté pour son rôle de passivation (i.e. protection contre la sélénisation).

La couche de passivation 7 a une résistivité suffisante pour que la résistance de « shunt » entre deux cellules soit d'au moins 500 $\Omega$ sur une longueur d'1 cm.

Avec pour hypothèse une largeur de gravure de 30 microns et une épaisseur de la couche de passivation 7 de 5nm, le matériau de la couche de passivation 7 a de préférence une résistivité d'au moins 0,1 $\Omega$.cm. Un matériau adapté est par exemple à base de : oxynitrure de titane. A noter qu'il convient d'éviter, si le matériau photoactif est par exemple de type p, un matériau semiconducteur de type n, car il en résulterait une hétérojonction p-n de polarité inversée qui nuirait aux performances de la cellule photovoltaïque.

En outre, si le même matériau est utilisé pour la couche barrière à la sélénisation et la couche de passivation, la résistivité de ce matériau sera de préférence inférieure ou égale à $10^4$ $\Omega$.cm. Il s'agit par exemple d'oxydes de métaux de transition ou d'oxynitrures de métaux de transition riches en oxygène.

D'une manière générale, il s'agit d'un matériau de tout type adapté pour protéger la couche principale 22 métallique d'une sélénisation ou sulfuration par la tranche et ayant la résistivité suffisante pour éviter un « shunt » (court-circuit) entre les cellules.

La couche de passivation 7 a une épaisseur adaptée pour protéger avec efficacité la tranche du revêtement électrode 6.

Si la couche de passivation 7 est très fine, elle risque de ne plus avoir une influence significative. Elle a ainsi par exemple une épaisseur supérieure ou égale à 3nm, de préférence supérieure ou égale à 5nm. De façon surprenante, il s'est en effet avéré qu'une couche de passivation 7 d'une si faible épaisseur avait un effet significatif de protection contre la sélénisation.

La couche barrière à la sélénisation 24 requiert une conductivité suffisante pour préserver la conductance du revêtement électrode 6.

Le matériau de la couche barrière à la sélénisation 24 a de préférence une résistivité inférieure ou égale à $10^4\Omega$.cm, comme expliqué précédemment.

La couche barrière à la sélénisation 24 est en outre de préférence apte à limiter la diffusion arrière des ions sodium vers le substrat porteur 2, c'est-à-dire la diffusion des ions sodium depuis le dessus de la couche supérieure 26, à travers la couche supérieure 26 et vers le substrat porteur 2.

Cette propriété est avantageuse à plusieurs égards.

Elle fiabilise les procédés de fabrication consistant à ajouter des alcalins pour former le matériau photoactif, par exemple par dépôt de diséléniure de sodium sur la couche supérieure 26 du revêtement électrode 6 ou par adjonction de sodium pendant le dépôt du matériau photoactif, par exemple en utilisant des cibles contenant du sodium ou autres alcalins, comme décrit dans US-B-5 626 688.

Le matériau de la couche barrière à la sélénisation 24 est par exemple à base d'un nitrure de métal tel que le nitrure de titane, le nitrure de molybdène, le nitrure de zirconium ou le nitrure de tantale, ou une combinaison de ces matériaux. Il peut également s'agir d'un oxynitrure.

D'une manière générale, il s'agit d'un matériau de tout type adapté pour protéger la couche principale 22 métallique d'une sélénisation ou sulfuration par le dessus et ayant la résistivité requise.

Il peut également être à base d'un oxyde métallique tel que l'oxyde de molybdène, l'oxyde de titane ou un oxyde mixte de molybdène et de titane.

Les nitrures sont cependant préférés aux oxydes.

De façon préférée encore, il s'agit d'un matériau à base d'un oxynitrure métallique avec M choisi parmi le titane, le molybdène, le zirconium ou le tantale, et avec un teneur en oxygène x= O/(O+N) avec 0<x<1, par exemple 0,05<x<0,95, par exemple 0,1<x<0,9.

Il est à noter que les nitrures, oxydes et oxynitrures ci-dessus peuvent être sous-stoechiométriques, stoechiométriques ou sur-stoechiométriques respectivement en azote et en oxygène.

En variante, il s'agit d'une couche à base de molybdène, plus précisément d'un composé à base de molybdène avec une teneur élevée en oxygène et/ou en azote. La teneur en oxygène et/ou en azote est par exemple suffisante si elle induit une résistivité supérieure ou égale à 20$\mu$Ohm.cm.

D'une manière générale, il s'agit donc d'une couche à base de molybdène avec une teneur élevée en oxygène et/ou en azote ou d'un matériau à base d'un nitrure, d'un oxyde ou d'un oxynitrure métallique adapté pour protéger la couche principale 22 à base de molybdène d'une sélénisation ou sulfuration éventuelle.

La couche barrière à la sélénisation a par exemple une résistivité comprise entre 200$\mu\Omega$.cm et 500$\mu\Omega$.cm dans le cas d'une couche à base d'un oxyde, nitrure ou oxynitrure métallique et une résistivité comprise entre 20$\mu\Omega$.cm et 50$\mu\Omega$.cm dans le cas d'un matériau à base de molybdène avec une teneur élevée en azote et/ou en oxygène.

La couche barrière à la sélénisation 24 est de faible épaisseur. Elle a une épaisseur inférieure ou égale à 50nm, de préférence inférieure ou égale à 30nm, de préférence encore inférieure ou égale à 15nm. Il s'agit par exemple d'une couche de 10nm.

Du fait de la faible épaisseur de la couche barrière à la sélénisation 24, une résistivité élevée (mais inférieure à $10^4 \Omega$.cm) ne nuit pas aux performances de la cellule, le courant électrique passant transversalement.

La couche principale métallique 22 a une épaisseur suffisante pour que le revêtement électrode 6 ait, après un test de sélénisation tel que décrit ci-dessus, une résistance par carré inférieure ou égale à $2\Omega/\square$, de préférence inférieure ou égale à $1\Omega/\square$. La présence de la couche supérieure 26 à base du métal M et de la couche barrière à la sélénisation 24 permet d'atteindre de telles performances.

Dans l'hypothèse d'un revêtement électrode 6 ne comprenant pas d'autres couches électroconductrices que la couche principale métallique 22, la couche barrière à la sélénisation 24 et la couche supérieure 26 à base du métal M, la couche principale métallique 22, pour avoir un effet significatif, a de préférence une épaisseur supérieure ou égale à 40nm, de préférence supérieure ou égale à 150nm. Toutefois, la couche principale métallique 22 a par exemple une épaisseur inférieure ou égale à 400nm, par exemple inférieure ou égale à 300nm, par exemple inférieure ou égale à 250nm.

La couche principale métallique 22 est de préférence à base de cuivre, par exemple composée entièrement de cuivre. En variante cependant, il s'agit d'un matériau de tout type adapté, par exemple à base d'aluminium, ou à base de molybdène. D'une manière générale, il s'agit d'un métal ou alliage de tout type adapté.

A noter que le revêtement électrode 6 décrit comprend une couche principale métallique 22, une couche barrière à la sélénisation 24 et une couche supérieure métallique 26 à base d'un métal M.

En variante cependant, le revêtement électrode 6 comprend plusieurs couches, par exemple plusieurs couches métalliques, sous la couche barrière à la sélénisation 24.

En variante encore, le revêtement électrode 6 ne comprend pas de couche barrière à la sélénisation et la couche supérieure métallique 26 est alors par exemple formée directement sur la couche principale métallique 22.

Ainsi, d'une manière générale, le substrat de contact arrière 1 comprend un substrat porteur 2 et un revêtement électrode 6 comprenant :

- une couche principale métallique 22 formée sur le substrat porteur 2 ; et
- une couche supérieure 26 à base d'un métal M formée sur la couche principale métallique 22.

Le métal M est propre à former, après sulfuration et/ou sélénisation, une couche de contact ohmique avec le matériau semi-conducteur photoactif, notamment avec un matériau semi-conducteur photoactif à base de chalcopyrite de cuivre et de sélénium et/ou de soufre par exemple un matériau photoactif de type $Cu(In,Ga)(S,Se)_2$, notamment CIS ou CIGS, ou encore un matériau de type $Cu_2(Zn,Sn)(S,Se)_4$.

On entend par une couche de contact ohmique une couche d'un matériau tel que la caractéristique courant / tension du contact est non-rectifiante et linéaire.

De préférence, la couche supérieure 26 est la dernière couche supérieure du revêtement électrode 6, c'est-à-dire que le revêtement électrode 6 ne possède pas une autre couche au-dessus de la couche 26.

De préférence également, le revêtement électrode 6 comprend une seule couche principale 22 métallique, une seule couche barrière à la sélénisation 24, et une seule couche supérieure métallique 26 à base du métal M.

Il est à noter qu'on entend, dans tout le texte, par « une seule couche », une couche d'un même matériau. Cette unique couche peut néanmoins être obtenue par la superposition de plusieurs couches d'un même matériau, entre lesquelles existe une interface qu'il est possible de caractériser, comme décrit dans WO-A-2009/080931.

Typiquement, dans une enceinte de dépôt magnétron, plusieurs couches d'un même matériau seront formées successivement sur le substrat porteur par plusieurs cibles pour former au final une seule couche du même matériau, à savoir le molybdène.

La couche 26 est destinée à être intégralement transformée par sélénisation et/ou sulfuration en $Mo(S,Se)_2$, lequel matériau n'est pas considéré comme un matériau « à base de molybdène » mais un matériau à base de disulfure de molybdène, de diséléniure de molybdène ou d'un mélange de disulfure et de diséléniure de molybdène.

De manière conventionnelle, la notation (S,Se) indique qu'il s'agit d'une combinaison de $S_xSe_{1-x}$ avec $0 \le x \le 1$.

Il est important de noter que le substrat illustré sur la figure 1 et décrit ci-dessus est un produit intermédiaire dans la fabrication d'un module photovoltaïque. Ce produit intermédiaire est ensuite transformé du fait du procédé de fabrication du matériau photoactif. Le substrat de contact arrière 1 décrit ci-dessus s'entend comme le produit intermédiaire avant transformation, lequel peut être stocké et acheminé vers d'autres sites de production pour la fabrication du module.

La couche supérieure 26, de façon à jouer son rôle de contact ohmique une fois transformée en $Mo(S,Se)_2$, a par exemple une épaisseur supérieure ou égale à 10nm, et inférieure ou égale à 100nm, de préférence comprise entre 30nm et 50nm. Une épaisseur importante n'est pas nécessaire.

Ledit métal M est avantageusement à base de molybdène et/ou de tungstène.

Les composés de disulfure et/ou de diséléniure de molybdène $Mo(S,Se)_2$ sont des matériaux dont l'efficacité comme couche de contact ohmique est prouvée. Le tungstène (W) est un matériau aux propriétés chimiques analogues. Il forme également des semi-conducteurs chalcogénides $WS_2$ et $WSe_2$. $Mo(S,Se)_2$ et

W(S,Se)$_2$ peuvent tous deux être formés comme des semi-conducteurs de type p avec un dopage de type p supérieur ou égale à 10$^{16}$/cm$^3$ et un travail de sortie d'environ 5ev. D'une manière générale, il peut s'agir d'un matériau à base d'un métal M propre à former un composé de type sulfure et/ou séléniure semi-conducteur de type p avec une concentration de porteurs de charge supérieure ou égale à 10$^{16}$/cm$^3$ et un travail de sortie supérieur ou égal à 4,5eV. Plus généralement encore, il s'agit d'un métal M de tout type apte à former, après sulfuration et/ou sélénisation, une couche de contact ohmique avec un matériau semi-conducteur photoactif, plus particulièrement avec un matériau photoactif à base de chalcopyrite de cuivre et de sélénium et/ou de soufre.

Le substrat de contact arrière 1 avec la couche barrière aux alcalins 4 est destiné à la fabrication d'un matériau photoactif avec adjonction de sodium (il est connu que le sodium améliore les performances des matériaux photoactifs de type CIS ou CIGS). La couche barrière aux alcalins 4 empêche la migration des ions sodium depuis le substrat 2 en verre, pour un meilleur contrôle de l'adjonction de sodium dans le matériau photoactif.

Dans le cas où le substrat 2 ne contient pas d'ions alcalins, la couche barrière aux alcalins 4 peut être omise.

Cependant, une autre technique de fabrication du matériau photoactif consiste à utiliser la migration des ions sodium depuis le substrat porteur en verre 2 pour former le matériau photoactif. Dans ce cas, le substrat de contact arrière 1 ne possède pas de couche barrière aux alcalins 4 et la couche principale métallique 22 est par exemple formée directement sur le substrat porteur 2.

Le substrat porteur 2 et la couche barrière aux alcalins 4 vont maintenant être décrits.

Les deux cas ci-dessus sont à distinguer. Le cas où une migration d'ions alcalins depuis le substrat 2 est souhaitée pour doper la couche de matériau photoactif et le cas où cette migration n'est pas souhaitée.

Dans le deuxième cas, les substrats 2 sont généralement pourvus d'une ou plusieurs couches barrières aux alcalins 4 pour permettre d'utiliser comme substrat une feuille de verre de type silico-sodo-calcique obtenue par flottage, verre d'un coût relativement faible et qui présente toutes les qualités que l'on connait à ce type de matériau, comme par exemple sa transparence, son imperméabilité à l'eau et sa dureté.

La teneur en ions alcalins du substrat 2 est dans ce cas un inconvénient que la couche barrière aux alcalins vient minimiser.

La couche barrière aux alcalins 4 est par exemple à base de l'un des matériaux choisis parmi : le nitrure, l'oxyde, l'oxynitrure ou l'oxycarbure de silicium, l'oxyde ou l'oxynitrure d'aluminium.

En variante, toujours dans le deuxième cas, le substrat porteur 2 est une feuille d'un matériau de tout type adapté, par exemple un verre à base de silice ne contenant pas d'alcalins, tels que les verres borosilicatés, ou en matière plastique, ou même en métal.

Dans le premier cas (migration d'ions souhaitée), le substrat porteur 2 est de tout type adapté et contient des alcalins, par exemple des ions sodium et potassium. Le substrat est par exemple un verre silico-sodo-calcique. La couche barrière aux alcalins est absente.

Dans les deux cas, le substrat porteur 2 est destiné à servir de contact arrière dans le module photovoltaïque et ne nécessite pas d'être transparent. Il peut s'agir par exemple d'une feuille métallique.

La feuille constituant le substrat porteur 2 peut être plane ou bombée, et présenter tout type de dimensions, notamment au moins une dimension supérieure à 1 mètre.

L'invention a également pour objet un procédé de fabrication du substrat de contact arrière 1 décrit ci-dessus.

Le procédé comprend des étapes consistant à :

- déposer une couche principale 22 métallique sur un substrat porteur 2 ;
- déposer, sur la couche principale métallique 22, avec interposition éventuelle d'autres couches, notamment d'une couche barrière à la sélénisation 24, une couche supérieure métallique 26 à base d'un métal M propre à former, après sulfuration et/ou sélénisation, une couche de contact ohmique avec un matériau semi-conducteur photoactif ;

- former une tranchée par gravure à travers la couche supérieure métallique 26, l'éventuelle couche barrière à la sélénisation 24 et la couche principale métallique 22 ; et
- déposer à l'intérieur de la tranchée une couche de passivation 7 apte à protéger la couche principale métallique de la sélénisation,
- transformer la couche supérieure 26 à base de métal M en un sulfure et/ou séléniure du métal M.

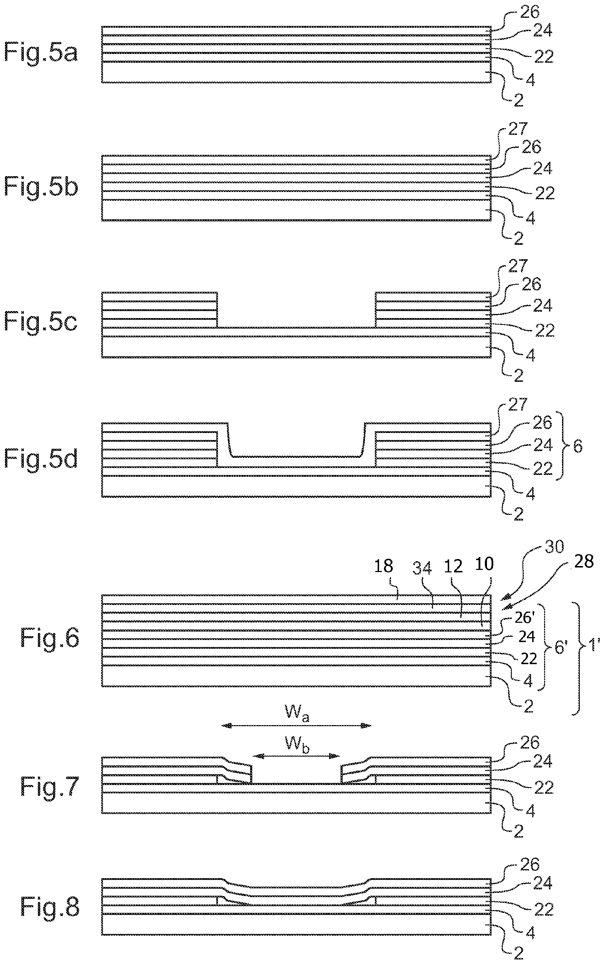

Pour ce faire, un masque 27 est par exemple utilisé, comme illustré sur les figures 5a-5d.

Un masque d'une résine ou autre matériau de tout type adapté est par exemple déposé sur le revêtement électrode 6, plus particulièrement sur la couche supérieure métallique 26.

La gravure de la tranchée P1 est réalisée après dépôt de la couche de résine et forme ainsi un masque 27 ne laissant à découvert que la ou les tranchée(s) 8 de gravure P1.

La couche de passivation 7 est ensuite déposée, par exemple par pulvérisation cathodique, sur l'ensemble du substrat ; i.e. sur le masque et les parties non couvertes par le masque. Le dépôt des différentes couches est par exemple réalisé par pulvérisation cathodique assistée par magnétron mais il s'agit en variante d'un autre procédé de tout type adapté.

Le masque est ensuite retiré, de façon à obtenir le substrat de contact arrière illustré sur la figure 1.

De manière à permettre un retrait facile bien que le masque soit recouvert d'une couche mince, on utilisera par exemple une résine sensible aux ultraviolets et un éclairage ultraviolet détruisant la résine (i.e. par photolithographie). L'étape de « ashing » par UV est par exemple suivie d'une étape de « lift-off ».

Le substrat de contact arrière peut alors être utilisé pour déposer le matériau photoactif et former un dispositif semi-conducteur.

L'invention a également pour objet un dispositif semi-conducteur 28 (figure 6) utilisant le substrat de contact arrière 1 décrit ci-dessus pour y former une ou plusieurs couches photoactives 10, 12.

La première couche photoactive 10 est typiquement une couche dopée de type p, par exemple à base de chalcopyrite de cuivre Cu, d'indium In, et de sélénium Se et/ou de soufre S. Il peut s'agir, par exemple, comme expliqué précédemment, de CIS, CIGS ou CZTS.

La deuxième couche photoactive 12 est dopée de type n et dite tampon. Elle est par exemple composée de CdS (sulfure de cadmium) et formée directement sur la première couche photoactive 10.

En variante, la couche tampon 12 est par exemple à base de $In_xS_y$, Zn(O,S), ou ZnMgO ou dans un autre matériau de tout type adapté. En variante également, la cellule ne comprend pas de couche tampon, la première couche photoactive 10 pouvant elle-même former une homojonction p-n.

D'une manière générale, la première couche photoactive 10 est une couche de type p ou à homojonction p-n obtenue par addition d'éléments alcalins.

Le dépôt de la couche photoactive comprend des étapes de sélénisation et/ou de sulfuration, comme expliqué plus en détail ci-dessous. Le dépôt peut être réalisé par évaporation des éléments Cu, In, Ga et Se (ou Cu, Sn, Zn, S). Lors de ces étapes de sélénisation et/ou de sulfuration, la couche supérieure 26 à base du métal M est transformée en une couche 26' à base de $M(S,Se)_2$. Cette transformation concerne par exemple l'intégralité de la couche supérieure 26.

La sélénisation et/ou sulfuration de la couche photoactive réalise la sélénisation et/ou sulfuration de la couche supérieure métallique (e.g. à une température supérieure ou égale à 300°C). Cette étape de transformation de la couche supérieur métallique 26 peut être une étape séparée avant la formation la couche semi-conductrice CIS, CGS ou CZTS ou une étape réalisée pendant la sélénisation et/ou sulfuration de la couche semi-conductrice CIS, CGS ou CZTS, que cette sélénisation et/ou sulfuration soit réalisée pendant le dépôt de ladite couche semi-conductrice ou après le dépôt de composants métalliques dits précurseurs de la couche semi-conductrice.

Le dispositif semi-conducteur 28 comprend donc :

- le substrat porteur 2 et le revêtement électrode 6' formé sur le substrat porteur 2 et dont la couche supérieure 26' a été transformée ;

- la ou les couches photoactives 10, 12 formée(s) sur le revêtement électrode 6 et la couche de passivation 7 présente dans la ou les tranchée(s) 8 (non visibles sur la figure 6).

Le revêtement électrode 6' comprend :

- la couche principale métallique 22 ;
- la couche barrière à la sélénisation 24 formée sur la couche principale métallique 22 ; et
- la couche supérieure 26' de contact ohmique, à base de $M(S,Se)_2$, formée sur la couche barrière à la sélénisation 24.

Sur la couche de contact ohmique 26' et la couche de passivation 7 et en contact avec celles-ci, le dispositif semi-conducteur comprend ainsi la ou les couches semi-conductrices photoactives 10, 12.

Les éventuelles gravures de type P2 sont alors réalisées.

L'invention a également pour objet un module photovoltaïque 30 comprenant un dispositif semi-conducteur 28 tel que décrit ci-dessus.

Le module comprend par exemple, comme illustré sur la figure 6 :

- le dispositif semi-conducteur 28 formé par les couches 22, 24, 26', 10 et 12 ;
- un revêtement électrode transparent 18, par exemple en ZnO :Al, formé sur la première couche photoactive 10, et sur la couche tampon 12 en cas de présence de cette dernière, avec interposition éventuelle entre le revêtement électrode transparent 18 et le dispositif semi-conducteur 28 d'une couche intermédiaire 34, par exemple de ZnO intrinsèque ou de ZnMgO intrinsèque.

Le revêtement électrode transparent 18 comprend en variante une couche d'oxyde de zinc dopée avec du gallium, ou du bore, ou encore une couche d'ITO.

D'une manière générale, il s'agit d'un matériau conducteur transparent (TCO) de tout type adapté.

Pour une bonne connexion électrique et une bonne conductance, une grille métallique (non représentée sur la figure 6) est ensuite optionnellement déposée sur le revêtement électrode transparent 18, par exemple à travers un masque, par exemple par faisceau d'électrons. Il s'agit par exemple d'une grille de Al (aluminium) par exemple d'environ 2μm d'épaisseur sur laquelle est déposée une grille de Ni (nickel) par exemple d'environ 50nm d'épaisseur pour protéger la couche de Al.

Les gravures 20 de type P3 sont alors réalisées.

Le module 30 est ensuite protégé des agressions extérieures. Il comprend par exemple à cet effet un contre-substrat (non représenté) couvrant le revêtement électrode avant 18 et feuilleté au substrat porteur 2 par l'intermédiaire d'un intercalaire de feuilletage (non représenté) en matière thermoplastique. Il s'agit par exemple d'une feuille en EVA, PU ou PVB.

Grâces aux différentes gravures ou traitement lasers, le module photovoltaïque 30 compte plusieurs cellules photovoltaïques formées sur le même substrat 2, reliées en série entre elles.

L'invention a encore pour objet un procédé de fabrication du dispositif semi-conducteur 28 et du module photovoltaïque 30 ci-dessus, lequel procédé comprend une étape de formation d'une couche photoactive par sélénisation et/ou sulfuration.

Il existe de nombreux procédés connus de fabrication d'une couche photoactive de type $Cu(In,Ga)(S,Se)_2$. La couche photoactive 10 est par exemple une couche de CIGS formée de la façon suivante.

Dans une première étape, les précurseurs de la couche sont déposés sur le revêtement électrode 6.

Un empilement métallique composé d'une alternance de couches de type CuGa et In est par exemple déposé par pulvérisation cathodique magnétron à température ambiante, sur le revêtement électrode 6. Une couche de sélénium est ensuite déposée à température ambiante directement sur l'empilement métallique, par exemple par évaporation thermique.

En variante, l'empilement métallique a par exemple une structure multicouches de type Cu/In/Ga/Cu/In/Ga.....

Dans une deuxième étape, le substrat subit un traitement de chauffage à haute température dit RTP (« Rapid Thermal Process, RTP » en anglais), par exemple à environ 520°C dans une atmosphère composée par exemple de soufre gazeux, par exemple à base de S ou de $H_2S$, formant ainsi une couche de $CuIn_xGa_{1-x}(S,Se)_2$.

Un avantage de ce procédé est qu'il ne nécessite pas une source externe de vapeur de sélénium. La perte d'une partie du sélénium pendant le chauffage est compensé par un dépôt en excès de sélénium sur l'empilement métallique. Le sélénium nécessaire à la sélénisation est fourni par la couche de sélénium déposée.

En variante, la sélénisation est obtenue sans le dépôt d'une couche de sélénium mais par une atmosphère contenant du sélénium gazeux, par exemple à base de Se ou de $H_2Se$, préalablement à l'exposition à une atmosphère riche en soufre.

L'étape de sulfuration permet de s'abstenir éventuellement d'une couche tampon par exemple de CdS.

Comme expliqué ci-dessus, il peut être avantageux de procéder à un dépôt d'une couche à base d'alcalins, par exemple de sodium, pour un dosage précis du sodium dans la couche photoactive.

Préalablement au dépôt de l'empilement métallique CuGa et In, les alcalins sont par exemple introduits par le dépôt, sur la couche supérieure métallique 26, d'une couche de séléniure de sodium ou d'un composé contenant du sodium de façon à introduire par exemple de l'ordre de $2.10^{15}$ atomes de sodium par $cm^2$. L'empilement métallique est déposé directement sur cette couche de séléniure de sodium.

A noter qu'il existe de nombreuses variantes possibles pour former les couches de CI(G)S ou CZTS, lesquelles incluent par exemple la coévaporation des éléments mentionnée plus haut, le dépôt par vapeur chimique, le dépôt électrochimique de métaux, séléniures ou chalcopyrites, la pulvérisation réactive de métaux ou séléniures en présence de $H_2Se$ ou $H_2S$.

D'une manière générale, le procédé de fabrication de la couche photoactive 22 est de tout type adapté.

Tous les procédés de fabrication de couches de type CIS ou CZTS utilisent une étape de chauffage à haute température en présence de sélénium et/ou de soufre à l'état de vapeur ou à l'état liquide.

La figure 7 illustre une variante préférée de réalisation du substrat de contact arrière de la figure 1 pour laquelle seules les différences par rapport au mode de réalisation de la figure 1 seront décrites ci-dessous et sur laquelle des numéros de référence identiques concernent des éléments analogues.

Pour des substrats de grande surface, un procédé de masquage peut être coûteux.

Selon cette variante préférée, l'utilisation d'un masque n'est plus nécessaire. En lieu et place d'un procédé de masquage, deux tranchées de gravure P1 sont réalisées l'une sur l'autre, respectivement avant et après dépôt de la couche barrière à la sélénisation.

La couche barrière à la sélénisation fait aussi office de couche de passivation recouvrant la tranche de la couche principale métallique, i.e. il s'agit de la même couche. La couche barrière à la sélénisation est la partie de cette couche recouvrant la face supérieure de la couche principale métallique et la couche de passivation la partie de cette couche recouvrant en partie la tranchée de gravure de type P1 et ainsi la tranche de la couche principale métallique.

Une première tranchée de gravure de type P1 de largeur $w_a$ est réalisée dans la couche principale métallique, i.e. avant le dépôt d'une autre couche sur cette dernière. De façon à préserver la couche barrière aux alcalins, qui est par exemple en nitrure ou oxynitrure de silicium, un laser pulsé vert est par exemple utilisé.

Compte-tenu de la seconde gravure, il importe en effet de préserver la couche barrière aux alcalins dans le cas d'un substrat contenant des alcalins et d'une couche photoactive dopée par adjonction d'alcalins.

En variante, le margeage est par exemple également réalisé à travers la couche barrière aux alcalins.

Une deuxième tranchée de gravure de type P1 de largeur $w_b$ inférieure à la première tranchée est réalisée sur la première tranchée, à l'intérieur de celle-ci, de préférence centrée sur le milieu de la première tranchée, i.e. de façon à obtenir un profil symétrique.

La première tranchée a par exemple une largeur $w_a$ allant de 10 à 50 microns.

La deuxième gravure a par exemple une largeur $w_b$ allant de 10 à 90 % de la largeur $w_a$ de la première

tranchée.

De la même façon que dans le premier mode de réalisation, la couche de passivation recouvre la tranche de la couche principale métallique.

En outre, la couche de contact ohmique recouvre la couche de passivation.

Le matériau de la couche de passivation sera choisi de façon à pouvoir être utilisé comme matériau de couche barrière à la sélénisation, i.e. avec une résistivité adaptée, comme expliqué ci-dessus.

La figure 8 illustre une autre variante de réalisation préférée pour laquelle seules les différences par rapport au mode de réalisation de la figure 7 seront décrites ci-dessous et sur laquelle des numéros de référence identiques concernent des éléments analogues.

Dans cette variante encore, l'utilisation d'un masque n'est pas nécessaire, et seule une tranchée de gravure de type P1 est réalisée.

Pour cette variante, la couche de barrière à la sélénisation et la couche de passivation sont toujours une seule et même couche.

Un seul type de gravure P1 est réalisé. Il s'agit d'une gravure sur la couche principale métallique formant une tranchée analogue à la première tranchée du mode de réalisation de la figure 7.

La deuxième gravure du mode de réalisation de la figure 7 n'est pas réalisée.

Les matériaux de la couche de passivation et de la couche de contact ohmique doivent donc être choisis pour avoir une résistivité suffisante.

Elle doit par exemple être suffisante pour que la résistance de « shunt » à travers la tranchée P1 soit supérieure à 500 Ω (pour une cellule de longueur 1 cm).

$$R_{shunt}=\rho*p/(d*l)$$

La couche de contact ohmique étant entièrement sélénisée et/ou sulfurisée, sa résistivité est relativement importante et peut varier, en fonction de sa composition (e.g. teneur en oxygène), de sa teneur en alcalins et des conditions de croissance, de 0,1 à $10^4$ $\Omega$.cm.

Comme expliqué ci-dessus en référence au premier mode de réalisation et à la résistivité de la couche de passivation, une telle résistivité convient pour obtenir la résistance de shunt recherchée.

**Revendications**

1. Substrat de contact arrière (1) pour cellule photovoltaïque, comprenant un substrat porteur (2) et un revêtement électrode (6) comprenant une couche principale métallique (22), le revêtement électrode (6) présentant au moins une tranchée de gravure (8) traversant ladite couche principale métallique (22), dans lequel le substrat de contact arrière comprend une couche enrobante barrière à la sélénisation (7) recouvrant, à l'intérieur de la tranchée de gravure (8), la tranche de la couche principale métallique (22),

dans lequel ladite couche enrobante barrière à la sélénisation (7) est à base d'au moins un nitrure ou d'au moins un oxynitrure métallique d'un métal choisi parmi le titane, le molybdène, le zirconium ou le tantale et une teneur en oxygène x=O/(O+N) avec x= 0 ou 0<x<1, de préférence 0,05<x<0,95, de préférence 0,1<x<0,9.

2. Substrat de contact arrière (1) selon la revendication 1, dans lequel le revêtement électrode (6) comprend une couche recouvrante barrière à la sélénisation (24) formée sur la couche principale métallique (22).

3. Substrat de contact arrière (1) selon l'une quelconque des revendications précédentes, dans lequel ladite couche enrobante barrière à la sélénisation (7) est un composé à base de molybdène avec une teneur élevée en oxygène et/ou en azote.

4. Substrat de contact arrière (1) selon l'une quelconque des revendications précédentes, dans lequel ladite couche enrobante barrière à la sélénisation (7) a une résistivité comprise entre 20μOhm.cm et 50μOhm.cm.

5. Substrat de contact arrière (1) selon l'une quelconque des revendications précédentes, comprenant, sur la couche principale métallique (22), une couche supérieure métallique(26) à base d'un métal M propre à former, après sulfuration et/ou sélénisation, une couche de contact ohmique avec un matériau semi-conducteur photoactif, avec interposition éventuelle d'autres couches, notamment interposition d'une couche recouvrante barrière à la sélénisation (24) formée sur la couche principale métallique (22).

6. Substrat de contact arrière (1) selon la revendication précédente, dans lequel ladite couche supérieure (26) à base d'un métal M est à base de molybdène et/ou de tungstène.

7. Substrat de contact arrière (1) selon l'une quelconque des revendications précédentes prise ensemble avec la revendication 2, dans lequel ladite couche recouvrante barrière à la sélénisation (24) et ladite couche enrobante barrière à la sélénisation (7) sont deux parties d'une même couche.

8. Substrat de contact arrière (1) selon l'une quelconque des revendications 1 à 6, dans lequel ladite couche recouvrante barrière à la sélénisation (24) et ladite couche enrobante barrière à la sélénisation (7) sont deux couches distinctes, ladite couche enrobante barrière à la sélénisation (7) étant dans la tranchée de gravure (8).

9. Dispositif semi-conducteur (28) comprenant un substrat porteur (2) et un revêtement électrode (6') formé sur le substrat porteur (2), le revêtement électrode (6') comprenant :

- une couche principale métallique (22) ;
- une couche de contact ohmique (26') à base d'un composé de type sulfure et/ou séléniure d'un métal M, sur la couche principale métallique (22) ;
- une couche photoactive (10) en un matériau semi-conducteur photoactif à base de chalcopyrite de cuivre et de sélénium et/ou de soufre, par exemple un matériau de type $Cu(In,Ga)(S,Se)_2$, notamment CIS ou CIGS, ou encore un matériau de type $Cu_2(Zn,Sn)(S,Se)_4$, la couche photoactive (10) étant formée sur la couche de contact ohmique (26) ; et

dans lequel le revêtement électrode présente au moins une tranchée de gravure (8) traversant au moins ladite couche principale métallique (22) et dans lequel le substrat de contact arrière (1) comprend une couche enrobante barrière à la sélénisation (7) recouvrant, à l'intérieur de la tranchée de gravure (8), la tranche de la couche principale métallique (22),

dans lequel ladite couche enrobante barrière à la sélénisation (7) est à base d'au moins un nitrure ou d'au moins un oxynitrure métallique d'un métal choisi parmi le titane, le molybdène, le zirconium ou le tantale et une teneur en oxygène x=O/(O+N) avec x= 0 ou 0<x<1, de préférence 0,05<x<0,95, de préférence 0,1<x<0,9.

10. Module photovoltaïque (30) comprenant un dispositif semi-conducteur (28) selon la revendication 9, et un revêtement électrode transparent (18) formé sur la couche photoactive (10).

**Patentansprüche**

1. Rückkontaktsubstrat (1) für eine Photovoltaikzelle, das ein Trägersubstrat (2) und eine eine metallische Hauptschicht (22) enthaltende Elektrodenbeschichtung (6) enthält, wobei die Elektrodenbeschichtung (6) mindestens einen die metallische Hauptschicht (22) durchquerenden Ätzgraben (8) aufweist, wobei das Rückkontaktsubstrat eine umhüllende Selenisierungs-Barriereschicht (7) enthält, die im Inneren des Ätzgrabens (8) den Abschnitt der metallischen Hauptschicht (22) bedeckt, wobei die umhüllende Selenisierungs-Barriereschicht (7) auf Basis mindestens eines Nitrids oder mindestens eines metallischen Oxinitrids eines Metalls ist, das ausgewählt wird aus Titan, Molybdän, Zirconium oder Tantal und einem Sauerstoffgehalt x=O/(O+N) mit x=0 oder 0<x<1, vorzugsweise 0,05<x<0,95, vorzugsweise 0,1<x<0,9.

2. Rückkontaktsubstrat (1) nach Anspruch 1, wobei die Elektrodenbeschichtung (6) eine bedeckende Selenisierungs-Barriereschicht (24) enthält, die auf der metallischen Hauptschicht (22) geformt wird.

3. Rückkontaktsubstrat (1) nach einem der vorhergehenden Ansprüche, wobei die umhüllende Selenisierungs-Barriereschicht (7) eine Verbindung auf der Basis von Molybdän mit einem hohen Gehalt an Sauerstoff und/oder Stickstoff ist.

4. Rückkontaktsubstrat (1) nach einem der vorhergehenden Ansprüche, wobei die umhüllende Selenisierungs-Barriereschicht (7) einen spezifischen Widerstand zwischen 20$\mu$Ohm.cm und 50$\mu$Ohm.cm hat.

5. Rückkontaktsubstrat (1) nach einem der vorhergehenden Ansprüche, das auf der metallischen Hauptschicht (22) eine obere metallische Schicht (26) auf der Basis eines Metalls M enthält, die nach Schwefelung und/oder Selenisierung eine ohmsche Kontaktschicht mit einem photoaktiven Halbleitermaterial bilden kann, mit möglicher Zwischenfügung anderer Schichten, insbesondere Zwischenfügung einer bedeckenden Selenisierungs-Barriereschicht (24), die auf der metallischen Hauptschicht (22) gebildet wird.

6. Rückkontaktsubstrat (1) nach dem vorhergehenden Anspruch, wobei die obere Schicht (26) auf Basis eines Metalls M auf Basis von Molybdän und/oder Wolfram ist.

7. Rückkontaktsubstrat (1) nach einem der vorhergehenden Ansprüche zusammen mit Anspruch 2, wobei die bedeckende Selenisierungs-Barriereschicht (24) und die umhüllende Selenisierungs-Barriereschicht (7) zwei Teile einer gleichen Schicht sind.

8. Rückkontaktsubstrat (1) nach einem der Ansprüche 1 ä 6, wobei die bedeckende Selenisierungs-Barriereschicht (24) und die umhüllende Selenisierungs-Barriereschicht (7) zwei unterschiedliche Schichten sind, wobei die umhüllende Selenisierungs-Barriereschicht (7) sich im Ätzgraben (8) befindet.

9. Halbleitervorrichtung (28), die ein Trägersubstrat (2) und eine Elektrodenbeschichtung (6') enthält, die auf dem Trägersubstrat (2) geformt ist, wobei die Elektrodenbeschichtung (6') enthält:

- eine metallische Hauptschicht (22);
- eine ohmsche Kontaktschicht (26') auf Basis einer Verbindung der Art Sulfid und/oder Selenid eines Metalls M auf der metallischen Hauptschicht (22),
- eine photoaktive Schicht (10) aus einem photoaktiven Halbleitermaterial auf der Basis von Kupfer-Chalkopyrit und Selen und/oder Schwefel, zum Beispiel ein Material der Art Cu(In,Ga)(S,Se)$_2$, insbesondere CIS oder CIGS, oder auch ein Material der Art CU$_2$(Zn,Sn) (S,Se)$_4$, wobei die photoaktive Schicht (10) auf der ohmschen Kontaktschicht (26) gebildet wird; und

wobei die Elektrodenbeschichtung mindestens einen Ätzgraben (8) aufweist, der mindestens die metallische Hauptschicht (22) durchquert, und wobei das Rückkontaktsubstrat (1) eine umhüllende Selenisierungs-Barriereschicht (7) enthält, die im Inneren des Ätzgrabens (8) den Abschnitt der metallischen Hauptschicht (22) bedeckt,
wobei die umhüllende Selenisierungs-Barriereschicht (7) auf der Basis mindestens eines Nitrids oder mindestens eines metallischen Oxinitrids eines Metalls ist, das ausgewählt wird aus Titan, Molybdän, Zirconium oder Tantal, und einem Sauerstoffgehalt x=O/(O+N) mit x=0 oder 0<x<1, vorzugsweise 0,05<x<0,95, vorzugsweise 0,1<x<0,9.

10. Photovoltaisches Modul (30), das eine Halbleitervorrichtung (28) nach Anspruch 9 und eine transparente Elektrodenbeschichtung (18) enthält, die auf der photoaktiven Schicht (10) geformt wird.

**Claims**

1. Back contact substrate (1) for a photovoltaic cell, comprising a carrier substrate (2) and an electrode coating (6) comprising a main metal layer (22), the electrode coating (6) having at least one etched trench (8) passing through said main metal layer (22),
wherein the back contact substrate comprises an enclosing selenization barrier layer (7) covering, inside the etched trench (8), the edge of the main metal layer (22),
wherein said enclosing selenization barrier layer (7) is based on at least one metal nitride or at least one metal oxynitride of a metal selected from titanium, molybdenum, zirconium or tantalum, and an oxygen content x=O/(O+N) with x=0 or 0<x<1, preferably 0.05<x<0.95, preferably 0.1<x<0.9.

2. Back contact substrate (1) according to Claim 1, wherein the electrode coating (6) comprises a covering selenization barrier layer (24) formed on the main metal layer (22).

3. Back contact substrate (1) according to either one of the preceding claims, wherein said enclosing selenization barrier layer (7) is a molybdenum-based compound with a high oxygen and/or nitrogen content.

4. Back contact substrate (1) according to any one of the preceding claims, wherein said enclosing selenization barrier layer (7) has a resistivity of between 20 μohm.cm and 50 μohm.cm.

5. Back contact substrate (1) according to any one of the preceding claims, comprising, on the main metal layer (22), an upper metal layer (26) based on a metal M capable of forming, after sulfuration and/or selenization, a layer for ohmic contact with a photoactive semiconductor material, with optional interposition of other layers, in particular interposition of a covering selenization barrier layer (24) formed on the main metal layer (22).

6. Back contact substrate (1) according to the preceding claim, wherein said upper layer (26) based on a metal M is based on molybdenum and/or tungsten.

7. Back contact substrate (1) according to any one of the preceding claims taken together with Claim 2, wherein said covering selenization barrier layer (24) and said enclosing selenization barrier layer (7) are two parts of the same layer.

8. Back contact substrate (1) according to any one of Claims 1 to 6, wherein said covering selenization barrier layer (24) and said enclosing selenization barrier layer (7) are two separate layers, said enclosing selenization barrier layer (7) being in the etched trench (8).

9. Semiconductor device (28) comprising a carrier substrate (2) and an electrode coating (6') formed on the carrier substrate (2), the electrode coating (6') comprising:

- a main metal layer (22);
- an ohmic contact layer (26') based on a compound of the metal M sulfide and/or selenide type, on the main metal layer (22);
- a photoactive layer (10) of a photoactive semiconductor material based on chalcopyrite of copper and selenium and/or sulfur, for example a material of the type Cu(In,Ga)(S,Se)$_2$, in particular CIS or CIGS, or alternatively a material of the type Cu$_2$(Zn,Sn)(S,Se)$_4$, the photoactive layer (10) being formed on the ohmic contact layer (26);

wherein the electrode coating has at least one etched trench (8) passing through at least said main metal layer (22), and wherein the back contact substrate (1) comprises an enclosing selenization barrier layer (7) covering, inside the etched trench (8), the edge of the main metal layer (22),

wherein said enclosing selenization barrier layer (7) is based on at least one metal nitride or at least one metal oxynitride of a metal selected from titanium, molybdenum, zirconium or tantalum, and an oxygen content $x=O/(O+N)$ with $x=0$ or $0<x<1$, preferably $0.05<x<0.95$, preferably $0.1<x<0.9$.

10. Photovoltaic module (30) comprising a semiconductor device (28) according to Claim 9, and a transparent electrode coating (18) formed on the photoactive layer (10).

Fig.1

Fig.2

Fig.3a

Fig.4a

Fig.3b

Fig.4b

Fig.3c

Fig.4c

Fig.5a

Fig.5b

Fig.5c

Fig.5d

Fig.6

Fig.7

Fig.8

**EP 3 069 386 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 02065554 A
- WO 2013062298 A1
- US 5626688 B
- WO 2009080931 A